# EUROPEAN PATENT APPLICATION

(11) **EP 4 730 980 A1**
(43) Date of publication of application: **22.04.2026**
(21) Application number: 25200151.6
(22) Date of filing: 04.09.2025
(51) Int. Cl.: H10W 70/04

(54) **METHOD AND APPARATUS FOR DEFORMING A J-SHAPED LEAD OF A PACKAGED SEMICONDUCTOR DEVICE**

(30) Priority: 26.09.2024 CN 202411357467
(71) Applicant: NXP USA, Inc., Austin, TX 78735 (US)
(72) Inventor: Ma, Chao, 5656AG Eindhoven (NL); Yao, Jinzhong, 5656AG Eindhoven (NL); Pang, Xingshou, 5656AG Eindhoven (NL); Luo, Yongchao, 5656AG Eindhoven (NL); Bai, Zhigang, 5656AG Eindhoven (NL)
(74) Representative: Colaiuda, Antonella

(57) **Abstract**

A method of using an apparatus to deform a J-shaped lead of a packaged semiconductor device, wherein the J-shaped lead comprises a straight extended portion, a straight lead portion and a curved tip portion, wherein the J-shaped lead extends from the packaged semiconductor device by the straight extended portion along a first direction, wherein the straight lead portion is connected between the straight extended portion and the curved tip portion, and wherein the curved tip portion is curved toward a direction perpendicular to the first direction, the method comprising: moving a force component of the apparatus along a second direction; and converting the movement of the force component along the second direction into a movement of a pusher component of the apparatus along a third direction by means of a transfer mechanism. An apparatus for deforming a J-shaped lead of a packaged semiconductor device is also presented.

## Description

### BACKGROUND

The present invention relates to a method and apparatus for deforming a J-shaped lead of a packaged semiconductor device.

Integrated circuit (IC) packaging generally includes encasing a semiconductor die and enabling the connection from the electrical contacts of the die to a printed circuit board (PCB) or the like, on which a package is to be mounted. Quad Flat Packages (QFP) are generally square in shape and have gull-wing (GW) leads on all four sides. Plastic Leaded Chip Carrier (PLCC) packages are inexpensive package choices that come in square or rectangular shapes. They differ from other surface mounted devices in that they generally use J-shaped leads rather than gull-wing or L-shaped ones. This allows PLCC devices to be directly soldered onto a PCB or mounted on a socket and are more space-efficient than other packaging types. High Density Quad Flat Packages (HDQFP) combine the gull-wing leads of a QFP with the J-leads of a PLCC in two interstitial tiers of leads extending from the package body. With this configuration, HDQFP may effectively double the number of leads on the package periphery.

The name of J-shaped leads, also called and known as J-leads, means the leads curve snuggly underneath the packaged semiconductor device. As the name suggests, the leads are curved in a way that look like the letter 'J'. Conventional J-lead forming process comprises three main steps, which are tip forming step, shoulder forming step and final forming step.

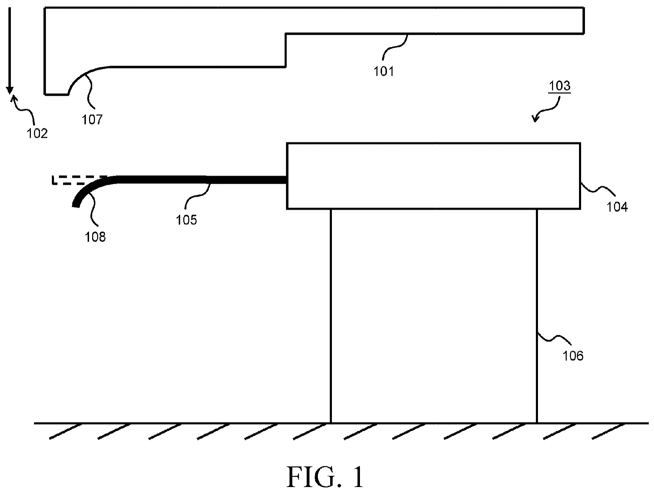

FIG. 1 shows a cross section of a die punch and a supporting stand used in tip forming step for a conventional J-lead forming process. After a pre-processed singulation step, one singulated packaged semiconductor device 103 is placed on a supporting stand 106. The skilled person will also appreciate and use other methods for fixing the packaged semiconductor device, such as placing the packaged semiconductor device on an anvil, clamping the packaged semiconductor device by using mechanical arms, etc. The packaged semiconductor device 103 comprises a main body 104 and a plurality of conductive leads extended from the main body 104. The main body, manufactured most commonly of plastic or ceramic, protects the fragile die encased inside the main body from contact with objects or solvents that could physically damage or corrode the circuitry on the die surface. As depicted in the cross section of FIG. 1, only one lead 105 of the plurality of leads is shown for reference, however, the skilled person will appreciate that the plurality of leads of the packaged semiconductor device can extend from either side of the main body. At the beginning of the process, the lead 105 is straight and extends from the main body 104 of the packaged semiconductor 103 with a required length during the pre-processed singulation step. A die punch 101 moves along a vertical direction 102 and contacts the lead 105 to bend the tip of the lead 105 to conform to a cambered surface 107 of the die punch 101, thereby forming an arc 108 at the tip of the lead 105.

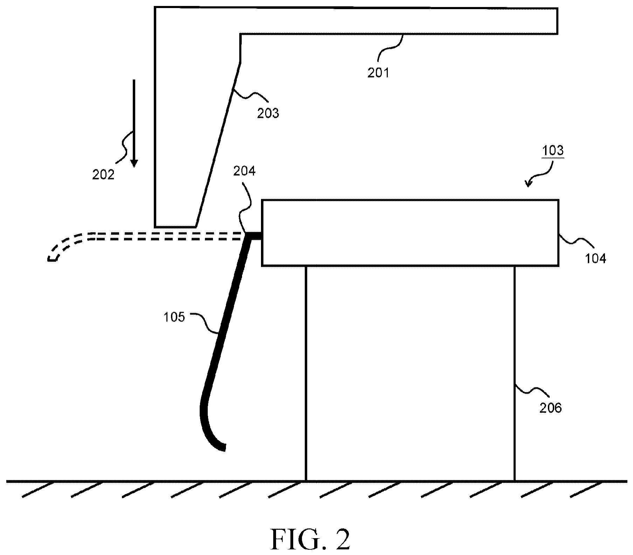

FIG. 2 shows a cross section of a die punch and a supporting stand used in shoulder forming step for a conventional J-lead forming process. After the tip forming step, the packaged semiconductor device 103 is placed on a supporting stand 206. A die punch 201 moves along a vertical direction 202 and contacts the lead 105 to bend a straight portion of the lead 105 to conform to a bevel 203 of the die punch 201, thereby forming a shoulder 204 in the lead 105. The straight portion of the lead 105 is thereby bent at an angle of about 15° to 20° with regard to the vertical direction.

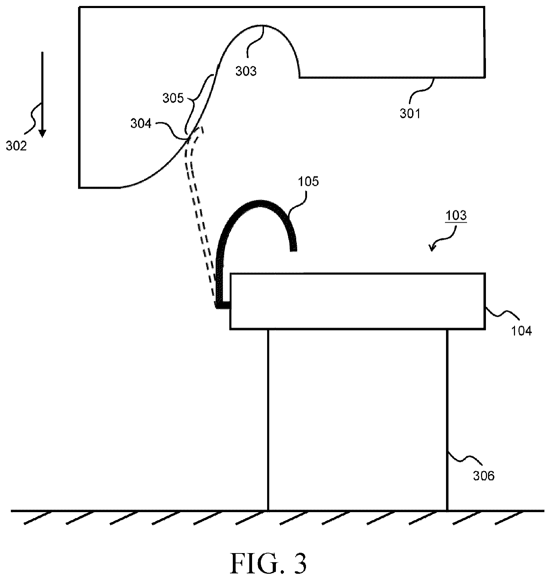

FIG. 3 shows a cross section of a die punch and a supporting stand used in final forming step for a conventional J-lead forming process. After the shoulder forming step, the packaged semiconductor device 103 is placed on a supporting stand 306. A die punch 301 moves along a vertical direction 302 and starts to contact the lead 105 from the contact point 304. The die punch 301 has a polished groove 303 of the same radius as is required for the final forming net shape of the J bend for the J-lead. The groove 303 has a lead-in 305 adjacent to the groove 303, consisting of a large-polished radius which further bends the formed lead from about 70° to 75° gradually to about 90° during the movement of the die punch in the vertical direction 302. After the lead's shoulder 204 is bent to a 90° angle, the groove 303 in the die punch 301 gives the final curl to the lead 105 and establish the overall height and width of the packaged outline as expected.

However, the long distance of the tip portion and the straight portion sliding along the lead-in 305 can result in a severe scratch on the lead 105. This will also bring J-lead burrs during the final forming step. Therefore, a technique is needed to provide a method and apparatus for making the J-lead forming smoother in the final forming step and reducing the J-lead burrs caused by the sliding friction between the J-lead and the die punch.

### SUMMARY

This summary is provided to introduce a selection of concepts in a simplified form that are further described below in the Detailed Description. This summary is not intended to identify key or essential features of the claimed subject matter, nor is it intended to be used to limit the scope of the claimed subject matter.

A method of using an apparatus to deform a J-shaped lead of a packaged semiconductor device, wherein the J-shaped lead comprises a straight extended portion, a straight lead portion and a curved tip portion, wherein the J-shaped lead extends from a main body of the packaged semiconductor device by the straight extended portion along a first direction which is parallel to a plane of a first major surface of the packaged semiconductor device, wherein the straight lead portion is at a first angle to the straight extended portion and connected between the straight extended portion and the curved tip portion, and wherein the curved tip portion is curved toward a direction perpendicular to the first direction, the method comprising: moving a force component of the apparatus along a second direction which is perpendicular to the first direction; and converting the movement of the force component along the second direction into a movement of a pusher component of the apparatus along a third direction which is opposite to the first direction by means of a transfer mechanism, wherein the pusher component is configured to be in contact with the curved tip portion, wherein during the pusher component is in contact with the curved tip portion, the movement of the pusher component along the third direction results in an inward movement of the curved tip portion relative to the main body of the packaged semiconductor device, thereby deforming the J-shaped lead.

An apparatus for deforming a J-shaped lead of a packaged semiconductor device, wherein the J-shaped lead comprises a straight extended portion, a straight lead portion and a curved tip portion, wherein the J-shaped lead extends from a main body of the packaged semiconductor device by the straight extended portion along a first direction which is parallel to a plane of a first major surface of the packaged semiconductor device, wherein the straight lead portion is at a first angle to the straight extended portion and connected between the straight extended portion and the curved tip portion, and wherein the curved tip portion is curved toward a direction perpendicular to the first direction, the apparatus comprising: a force component; and a pusher component, wherein the force component is configured to be movable along a second direction which is perpendicular to the first direction, wherein the movement of the force component along the second direction is convertible into a movement of the pusher component along a third direction which is opposite to the first direction by means of a transfer mechanism, wherein the pusher component is configured to be in contact with the curved tip portion, and wherein during the pusher component is in contact with the curved tip portion, the movement of the pusher component along the third direction results in an inward movement of the curved tip portion relative to the main body of the packaged semiconductor device, thereby deforming the J-shaped lead.

### BRIEF DESCRIPTION OF THE DRAWINGS

So that the manner in which the above recited features of the present disclosure can be understood in detail, a more detailed description of the disclosure may be had by reference to embodiments, some of which are illustrated in the appended drawings. The appended drawings illustrate only typical embodiments of the disclosure and should not limit the scope of the disclosure, as the disclosure may have other equally effective embodiments. The drawings are for facilitating an understanding of the disclosure and thus are not necessarily drawn to scale. Advantages of the subject matter claimed will become apparent to those skilled in the art upon reading this description in conjunction with the accompanying drawings, in which like reference numerals have been used to designate like elements, and in which:
FIG. 1 shows a cross section of a die punch and a supporting stand used in tip forming step for a conventional J-lead forming process;
FIG. 2 shows a cross section of a die punch and a supporting stand used in shoulder forming step for a conventional J-lead forming process;
FIG. 3 shows a cross section of a die punch and a supporting stand used in final forming step for a conventional J-lead forming process;
FIG. 4 and FIG. 5 respectively shows a cross section and a front view of an apparatus used for deforming a J-lead of a packaged semiconductor device in accordance with a first embodiment of the present disclosure;
FIG. 6 to FIG. 9 show cross sections of a process of using the apparatus for deforming a J-lead of a packaged semiconductor in accordance with the first embodiment of the present disclosure;
FIG. 10 and FIG. 11 show front views of the start and the end of the process of using the apparatus for deforming a J-lead of a packaged semiconductor in accordance with the first embodiment of the present disclosure;
FIG. 12 shows a cross section of an apparatus used for deforming a J-lead of a packaged semiconductor device in accordance with a second embodiment of the present disclosure;
FIG. 13 to FIG. 16 show cross sections of a process of using the apparatus for deforming a J-lead of a packaged semiconductor in accordance with the second embodiment of the present disclosure;
FIG. 17 shows a cross section of an apparatus used for deforming a J-lead of a packaged semiconductor device in accordance with a third embodiment of the present disclosure;
FIG. 18 to FIG. 23 show cross sections of a process of using the apparatus for deforming a J-lead of a packaged semiconductor in accordance with the third embodiment of the present disclosure;
FIG. 24 shows a front view of an apparatus used for deforming a J-lead of a packaged semiconductor device in accordance with a fourth embodiment of the present disclosure;
FIG. 25 and FIG. 26 show cross sections of intermediate steps of a process of using the apparatus for deforming a J-lead of a packaged semiconductor in accordance with the fourth embodiment of the present disclosure;
FIG. 27 and FIG. 28 show front views of the start and the end of the process of using the apparatus for deforming a J-lead of a packaged semiconductor in accordance with the fourth embodiment of the present disclosure;
FIG. 29 shows a cross section of an apparatus used for deforming a J-lead of a packaged semiconductor device in accordance with a fifth embodiment of the present disclosure;
FIG. 30 and FIG. 31 show cross sections of intermediate steps of a process of using the apparatus for deforming a J-lead of a packaged semiconductor in accordance with the fifth embodiment of the present disclosure;
FIG. 32 to FIG. 34 show cross sections of a process of final forming step after a J-lead of a packaged semiconductor device is deformed by using the apparatus in accordance with the present disclosure;
FIG. 35 to FIG. 37 depict top views of three setups for configuring and arranging the apparatus of the present disclosure in industrial pipelines.

### DETAILED DESCRIPTION

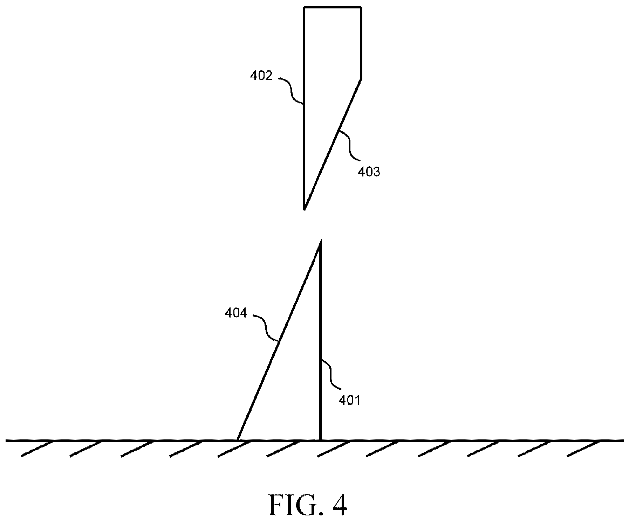

FIG. 4 shows a cross section of an apparatus used for deforming a J-lead of a packaged semiconductor device in accordance with a first embodiment of the present disclosure. The apparatus comprises two components, which are a pusher 401 placed on a ground or a working platform and a die punch 402 placed above the pusher 401. The skilled person will appreciate that the die punch 402 can be implemented by a mechanical power press driven by a motor and flywheel system, a hydraulic press using a hydraulic cylinder to generate a compressive force, a pneumatic power press used for punching purposes by means of high-pressure gas stored in an air cylinder as a power executive unit, an electromagnetic punch press driven by electromagnet produced by a flow of electric current or any other forcing component that can press on the pusher for fulfilling the function of deforming the J-lead described in the context of the present disclosure.

As shown in FIG. 4, the pusher 401 has a surface 404 and the die punch 402 has a surface 403. Each of the surfaces 403, 404 is planar and at an angle with regard to the vertical direction. The angle is preconfigured as 30° for the surface 403 and the surface 404 to the vertical direction. However, the skilled person will appreciate that the cross-section shapes of the pusher 401 and the die punch 402 are not limited to the shapes shown in FIG. 4. The pusher 401 and the die punch 402 of any cross-section shapes, sizes and textures that can fulfill the function of deforming the J-lead described in the context of the present disclosure is applicable. Also, the skilled person will appreciate that any angle for each mentioned surface 403, 404 with regard to the vertical direction and any relative positional relationships between the die punch 402 and the pusher 401 is applicable as long as both the mutual contact of the die punch and the pusher and the following movement of the die punch and the pusher caused by the mutual contact can fulfill the function of deforming the J-lead described in the context of the present disclosure.

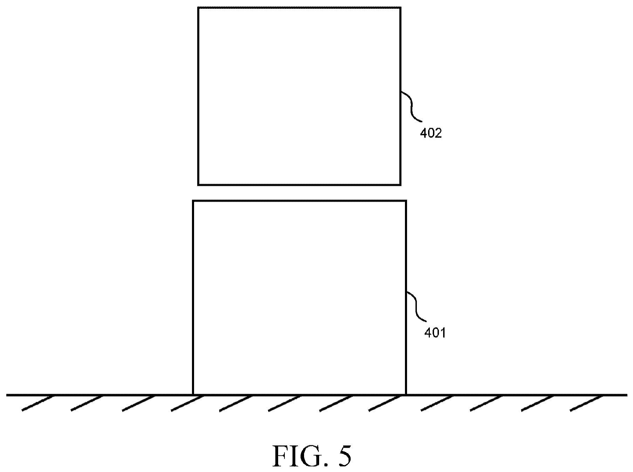

FIG. 5 shows a front view of the apparatus used for deforming a J-lead of a packaged semiconductor device in accordance with the first embodiment of the present disclosure. The pusher 401 is placed on a ground or a working platform and the die punch 402 is placed above the pusher 401. As shown in FIG. 5, the front-view shapes of both the die punch 402 and the pusher 401 are rectangular. The width of the pusher 401 is depicted to be wider than the die punch 402. However, the skilled person will appreciate that the front-view shapes of the pusher and the die punch are not limited to the shapes shown in FIG. 4. The pusher and the die punch of any front-view shapes, sizes, and relative positional relationships that can fulfill the function of deforming the J-lead described in the context of the present disclosure is applicable. Also, the skilled person will appreciate that any width of the pusher 401 is applicable as long as the width of the pusher is able to cover all the leads needed to be deformed.

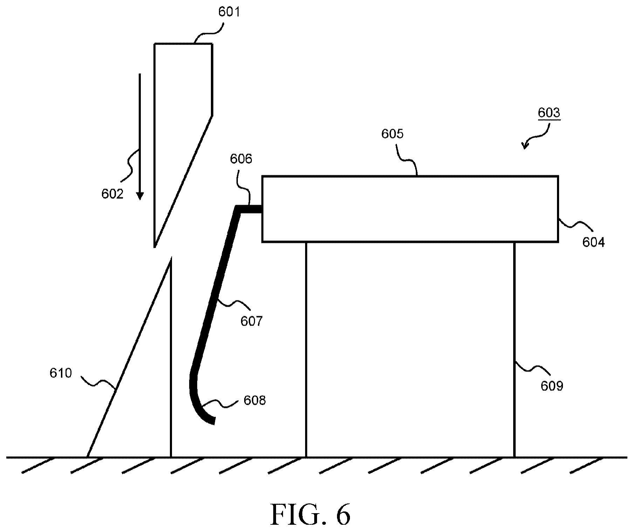

FIG. 6 to FIG. 9 show cross sections of a process of using the apparatus for deforming a J-lead of a packaged semiconductor in accordance with the first embodiment of the present disclosure.

As shown in FIG. 6, the apparatus comprises two components, which are a pusher 610 placed on a ground or a working platform and a die punch 601 placed above the pusher 610. After a pre-described J-lead shoulder forming step, a packaged semiconductor device 603 is placed on a supporting stand 609. The supporting stand 609 is placed on the same ground or the same working platform as the pusher 610. The skilled person will also appreciate and use other methods for fixing the packaged semiconductor device, such as placing the packaged semiconductor device on an anvil, clamping the packaged semiconductor device by using mechanical arms, etc. The packaged semiconductor device 603 comprises a main body 604 and a plurality of leads extended from the main body 604. As depicted in the cross section of FIG. 6, only one lead of the plurality of leads is shown for reference, however, the skilled person will appreciate that the plurality of leads of the packaged semiconductor device can extend from either side of the main body. As shown in FIG. 6, the J-lead comprises a straight extended portion 606, a straight lead portion 607 and a curved tip portion 608 after the pre-described J-lead shoulder forming step. The J-lead extends from the main body 604 by the straight extended portion 606 along a horizontal direction which is parallel to a plane of a major surface 605 of the packaged semiconductor device 603. The major surface 605 is covered by a molding compound extended till its edges and corresponding peripheral parts. The straight lead portion 607 is at an angle of 75° to the straight extended portion 606 and connected between the straight extended portion 606 and the curved tip portion 608. The curved tip portion 608 is curved toward a vertical direction. **It** will be appreciated that an initial angle other than 75° between the straight lead portion 607 and the straight extended portion 606 is also applicable as long as the pusher 610 can push the J-lead to the predetermined position for meeting the demand of deforming the J-lead described in the context of the present disclosure. As shown in FIG. 6, the die punch 601 is configured to move along a vertical direction 602 for contacting the pusher 610.

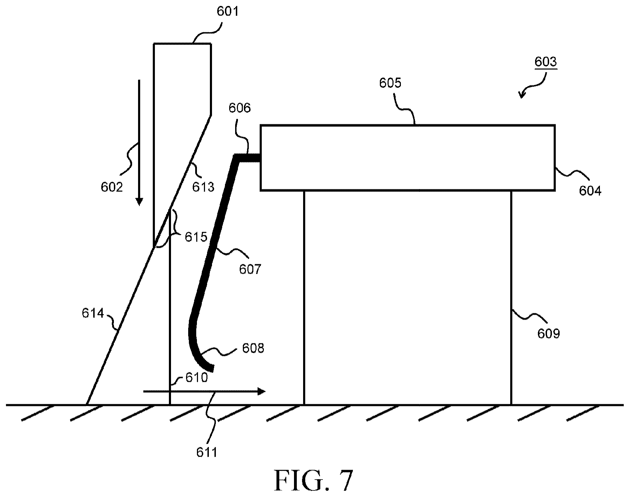

As shown in FIG. 7, along with the movement of the die punch 601 in the vertical direction 602, the die punch 601 has reached the pusher 610. The surface 613 of the die punch 601 is starting to contact with the surface 614 of the pusher 610. Along with the continuing movement of the die punch 601 in the vertical direction 602, the sliding contact distance 615 is increasing and the movement of the die punch 601 along the vertical direction 602 is converted into a movement of the pusher 610 along a horizontal direction 611 by means of the sliding contact between the surface 613 and the surface 614. The pusher 610 then moves along the horizontal direction 611 for contacting the J-lead.

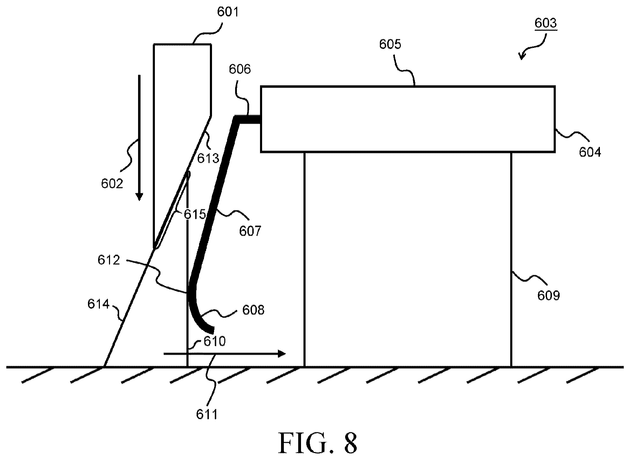

As shown in FIG. 8, along with the continuing movement of the die punch 601 in the vertical direction 602, the sliding contact distance 615 is further increasing. Along with the continuing movement of the pusher 610 in the horizontal direction 611, the pusher 610 has reached the J-lead at a contact point 612 of the curved tip portion 608. The pusher 610 is in contact with the curved tip portion 608.

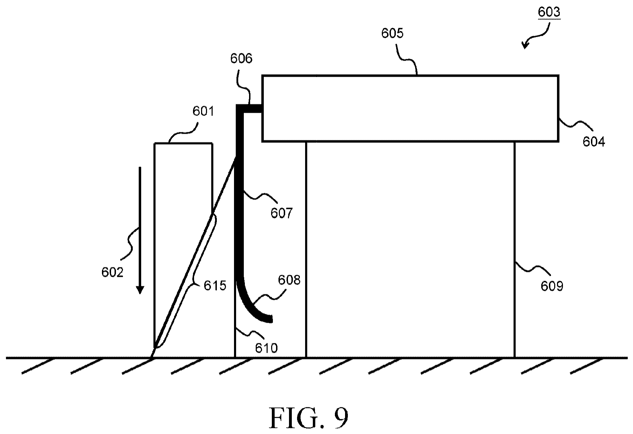

As shown in FIG. 9, along with the continuing movement of the pusher 610 in the horizontal direction after the pusher 610 is in contact with the curved tip portion 608, the curved tip portion 608 moves inward relative to the main body 604, thereby leading the straight lead portion 607 to move inward relative to the main body 604 as well. The pusher 610 stops at the position where the straight lead portion 607 reaches approximately to the vertical direction. Thus, the J-lead is deformed to a predetermined expected shape.

As the straight lead portion 607 is connected with the curved tip portion 608, the movement and the final position of the straight lead portion 607 is defined by the distance of the inward movement of the curved tip portion 608. The distance of the inward movement of the curved tip portion 608 is correlated with the distance of the movement of the pusher 610 along the horizontal direction, and the distance of the movement of the pusher 610 along the horizontal direction is correlated with the sliding contact distance 615, which relates to the movement of the die punch 601 along the vertical direction when the die punch 601 is in contact with the pusher 610. That is to say, in order to accurately configure the straight lead portion 607 to reach approximately to the vertical direction, an accurate movement of the die punch 601 along the vertical direction is preconfigured for acquiring an expected sliding contact distance 615, thereby acquiring an expected movement distance of the pusher 610 along the horizontal direction. A preferred sliding contact distance is around 6 millimeters, and a preferred movement distance of the pusher along the horizontal direction is around 1 millimeter. However, it will be appreciated that the expected sliding contact distance and the expected movement distance of the pusher along the horizontal direction are not limited to the mentioned parameters, but they are predetermined by user preferences considering the shapes, the sizes and the relative positional relationships of the die punch and the pusher, the space between two singulated packaged semiconductor devices for arranging the apparatus, the parameters of the J-leads, etc.

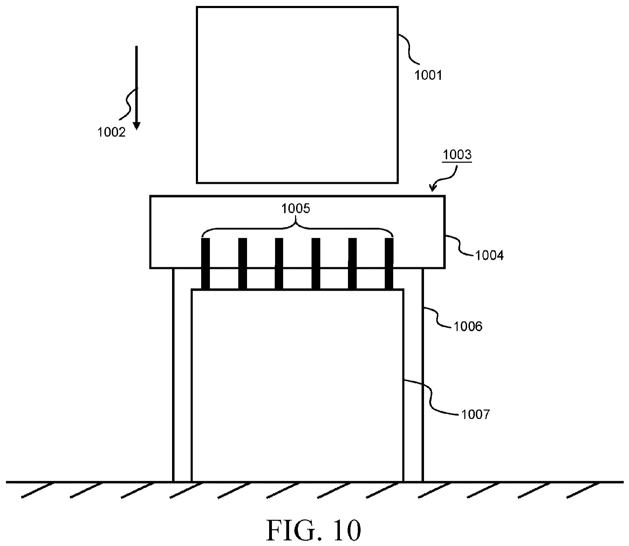

FIG. 10 shows a front view of the start of the process of using the apparatus for deforming a J-lead of a packaged semiconductor in accordance with the first embodiment of the present disclosure.

As shown in FIG. 10, the apparatus comprises two components, which are a pusher 1007 placed on a ground or a working platform and a die punch 1001 placed above the pusher 1007. After a pre-described J-lead shoulder forming step, a packaged semiconductor device 1003 is placed on a supporting stand 1006. The supporting stand 1006 is placed on the same ground or the same working platform as the pusher 1007. The packaged semiconductor device 1003 comprises a main body 1004 and a plurality of leads 1005 extended from the main body 1004. The width of the pusher 1007 covers all the plurality of the leads to be deformed. As depicted in the front view of FIG. 10, six leads are shown for reference, however, the skilled person will appreciate that the plurality of leads of the packaged semiconductor device with no amount limitation can extend from either side of the main body. As shown in FIG. 10, the die punch 1001 is configured to move along a vertical direction 1002 for contacting the pusher 1007.

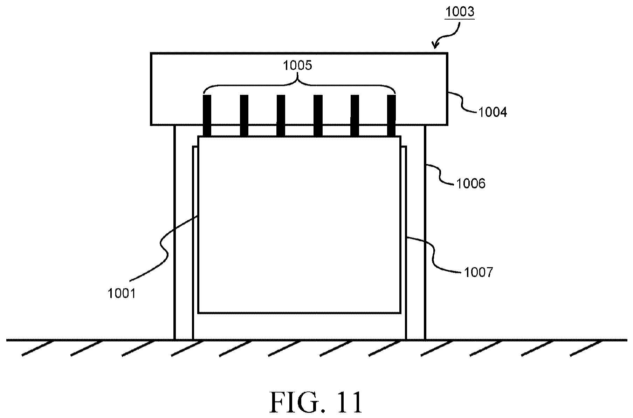

FIG. 11 shows a front view of the end of the process of using the apparatus for deforming a J-lead of a packaged semiconductor in accordance with the first embodiment of the present disclosure.

As shown in FIG. 11, when the plurality of leads 1005 are deformed to a predetermined expected shape, the die punch 1001 is in contact with the pusher 1007 but has not reached the ground or the working platform where the pusher 1007 is placed. It will be appreciated that the width of the die punch and the relative positional relationships of the die punch and the pusher from the start till the end of the process for deforming the leads are not limited as long as the movement and the contact of the die punch and the pusher can fulfill the function of deforming the J-lead described in the context of the present disclosure.

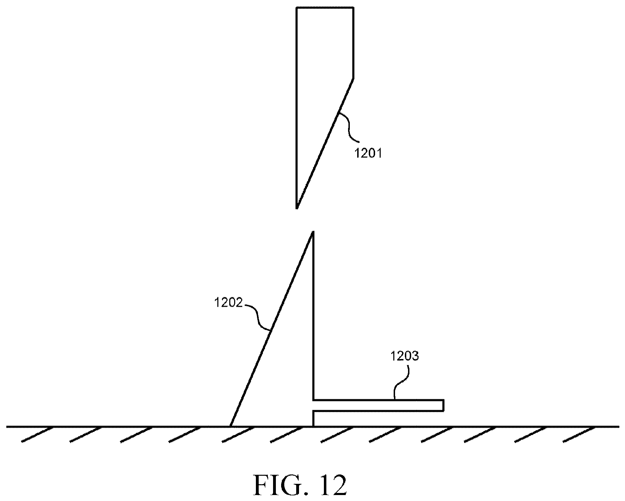

FIG. 12 shows a cross section of an apparatus used for deforming a J-lead of a packaged semiconductor device in accordance with a second embodiment of the present disclosure. The apparatus comprises two components, which are a pusher 1202 placed on a ground or a working platform and a die punch 1201 placed above the pusher 1202. As shown in FIG. 12, the pusher 1202 has a protruding structure 1203. It will be appreciated that the cross-section shapes of the pusher 1202 including the protruding structure 1203 and the die punch 1201 are not limited to the shapes shown in FIG. 12. The pusher 1202 and the die punch 1201 of any cross-section shapes, sizes and textures that can fulfill the function of deforming the J-lead described in the context of the present disclosure is applicable.

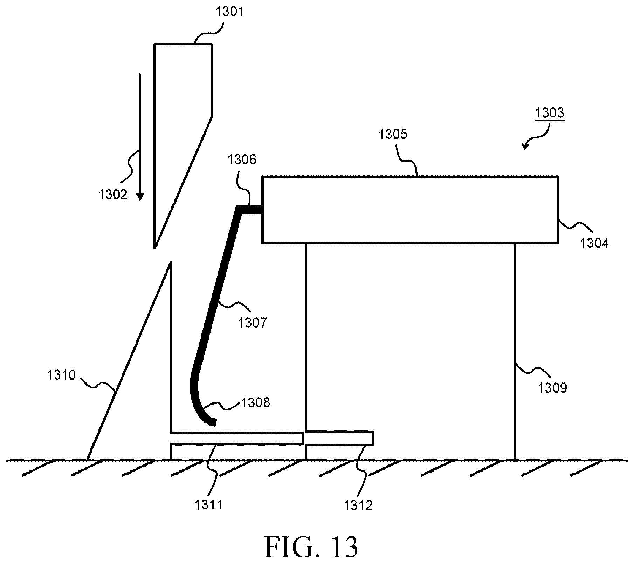

FIG. 13 to FIG. 16 show cross sections of a process of using the apparatus for deforming a J-lead of a packaged semiconductor in accordance with the second embodiment of the present disclosure. The apparatus for deforming a J-lead of a packaged semiconductor shown in FIG. 13 to FIG. 16 are similar to those shown in FIG. 6 to FIG. 9, but in which the pusher 1310 has a protruding structure 1311. The supporting stand 1309 shown in FIG. 13 to FIG. 16 are similar to those shown in FIG. 6 to FIG. 9, but in which the supporting stand 1309 has a hollow groove 1312, which is configured to be able to contain the protruding structure 1311. Other similar components are similarly labelled. As shown in FIG. 13, the die punch 1301 is configured to move along a vertical direction 1302 for contacting the pusher 1310.

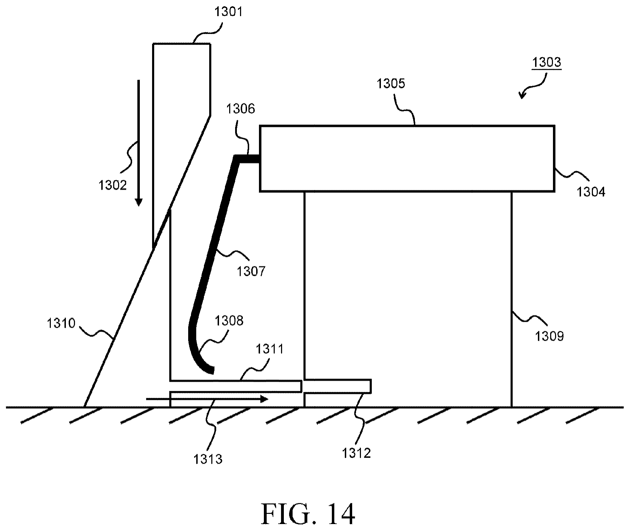

As shown in FIG. 14, along with the movement of the die punch 1301 in the vertical direction 1302, the die punch 1301 has reached the pusher 1310. Along with the continuing movement of the die punch 1301 in the vertical direction 1302, the movement of the die punch 1301 along the vertical direction 1302 is converted into a movement of the pusher 1310 along a horizontal direction 1313. The pusher 1310 then moves along the horizontal direction 1313 for contacting the J-lead.

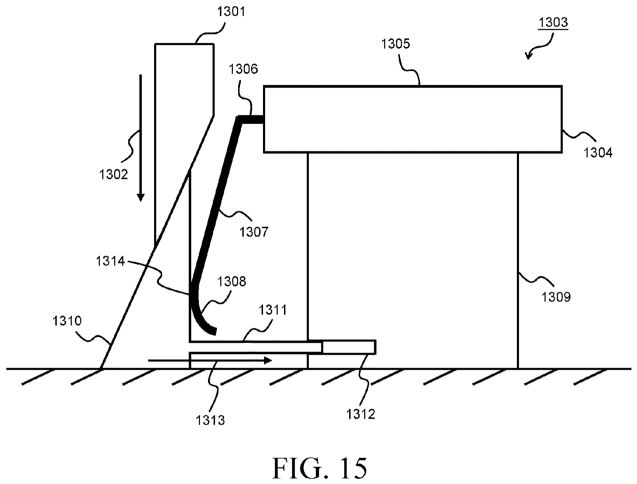

As shown in FIG. 15, along with the continuing movement of the die punch 1301 in the vertical direction 1302 and along with the continuing movement of the pusher 1310 in the horizontal direction 1313, the pusher 1310 has reached the J-lead at a contact point 1314 of the curved tip portion 1308. The pusher 1310 is in contact with the curved tip portion 1308. The protruding structure 1311 is inserted into the hollow groove 1312.

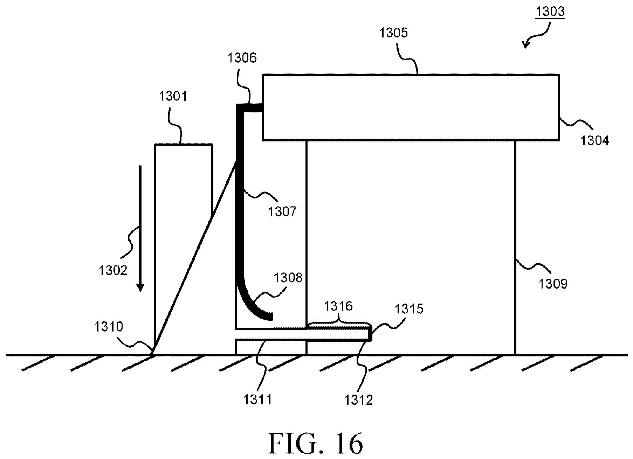

As shown in FIG. 16, along with the continuing movement of the pusher 1310 in the horizontal direction after the pusher 1310 is in contact with the curved tip portion 1308, the curved tip portion 1308 moves inward relative to the main body 1304, thereby leading the straight lead portion 1307 to move inward relative to the main body 1304 as well. The pusher 1310 stops at the position where the straight lead portion 1307 reaches approximately to the vertical direction. Thus, the J-lead is deformed to a predetermined expected shape. At the moment when the pusher 1310 stops, the hollow groove 1312 is filled with the inserted protruding structure and the inserted protruding structure has just reached the far end 1315 of the hollow groove 1312.

As the straight lead portion 1307 is connected with the curved tip portion 1308, the movement and the final position of the straight lead portion 1307 is defined by the distance of the inward movement of the curved tip portion 1308. The distance of the inward movement of the curved tip portion 1308 is correlated with the distance of the movement of the pusher 1310 along the horizontal direction, and the distance of the movement of the pusher 1310 along the horizontal direction is correlated with the length of a portion of the protruding structure 1311 which is inserted into the hollow groove 1312. That is to say, in order to accurately configure the straight lead portion 1307 to reach approximately to the vertical direction, an accurate depth 1316 of the hollow groove is preconfigured for acquiring an expected inserted distance of the protruding structure 1311, thereby acquiring an expected movement distance of the pusher 1310 along the horizontal direction. A preferred depth of the hollow groove is around 1 millimeter for the protruding structure to insert into, thereby the movement distance of the pusher along the horizontal direction is correspondingly around 1 millimeter.

As shown in FIG. 13, the protruding structure 1311 is positioned external to the hollow groove 1312 and just adjacent to the opening of the hollow groove 1312 at the beginning of the process for deforming the J-lead. However, it will be appreciated that the shapes and the relative positional relationship of the protruding structure and the hollow groove at the beginning of the process for deforming the J-lead are not limited as long as the space in the hollow groove is enough to contain the protruding structure for fulfilling the function of deforming the J-lead described in the second embodiment of the present disclosure. Also, it will be appreciated that preferred depth of the hollow groove and the movement distance of the pusher along the horizontal direction are not limited to the mentioned parameters, but they are predetermined by user preferences considering the shapes, the sizes and the relative positional relationships of the die punch and the pusher, the space between two singulated packaged semiconductor devices for arranging the apparatus, the parameters of the J-leads, etc. In addition, it will be appreciated that a sensor can be preconfigured at the protruding structure's side or at the supporting stand's side for monitoring whether the inserted protruding structure has reached the far end 1315 of the hollow groove 1312. When it is monitored by the sensor that the inserted protruding structure has just reached the far end of the hollow groove, a corresponding predetermined signal is triggered. Upon receiving the predetermined signal which indicates the J-lead has been deformed to the predetermined expected shape, it will be appreciated that the die punch can be configured to move back to its initial position along a direction right opposite to the vertical direction 1302 mechanically (e.g. utilizing a reaction force produced from the contacted sliding surface between the die punch and the pusher) or electronically (e.g. controlled by a motor system) or by any other signal-driven means.

Comparing with the first embodiment of the present disclosure, the solution of the second embodiment only utilizes a protruding structure of the pusher to define the movement distance of the pusher along the horizontal direction. In the second embodiment, there is no need for a user to calculate an accurate parameter and preconfigure an accurate movement of the die punch along the vertical direction for acquiring an expected sliding contact distance and an expected movement distance of the pusher as described in the first embodiment of the present disclosure. This will further save cost and decrease design complexity for the die punch of the present disclosure.

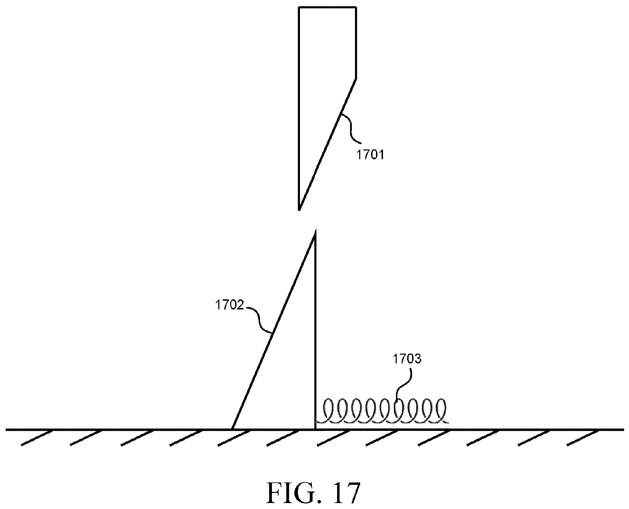

FIG. 17 shows a cross section of an apparatus used for deforming a J-lead of a packaged semiconductor device in accordance with a third embodiment of the present disclosure. The apparatus comprises two components, which are a pusher 1702 placed on a ground or a working platform and a die punch 1701 placed above the pusher 1702. As shown in FIG. 17, a spring 1703 is coupled with the pusher 1702. It will be appreciated that the cross-section shapes of the pusher 1702 including the spring 1703 and the die punch 1701 are not limited to the shapes shown in FIG. 17. The pusher 1702 including the spring 1703 and the die punch 1701 of any cross-section shapes, sizes and textures that can fulfill the function of deforming the J-lead described in the context of the present disclosure is applicable.

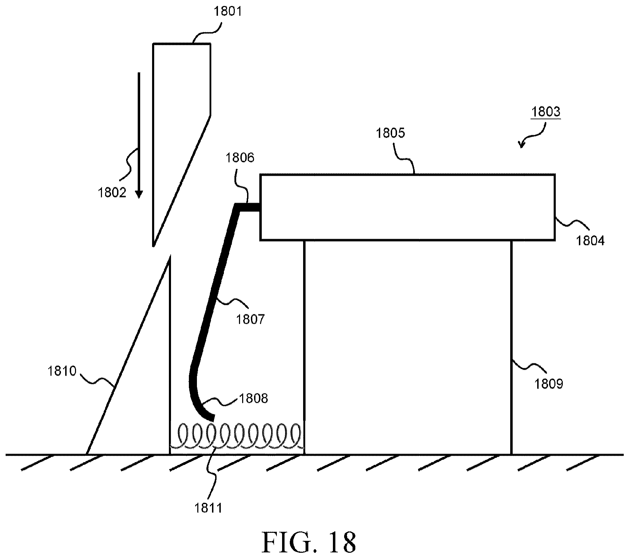

FIG. 18 to FIG. 23 show cross sections of a process of using the apparatus for deforming a J-lead of a packaged semiconductor in accordance with the third embodiment of the present disclosure. The apparatus for deforming a J-lead of a packaged semiconductor shown in FIG. 18 to FIG. 23 are similar to those shown in FIG. 6 to FIG. 9, but in which a spring 1811 is coupled between the pusher 1810 and the supporting stand 1809. The spring 1811 is configured to be compressible/extendable along with the movement of the pusher 1810 along the horizontal direction. Other similar components are similarly labelled. As shown in FIG. 18, the die punch 1801 is configured to move along a vertical direction 1802 for contacting the pusher 1810.

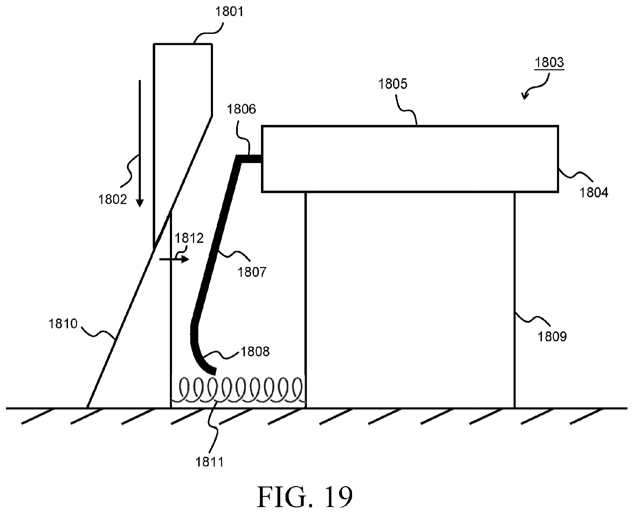

As shown in FIG. 19, along with the movement of the die punch 1801 in the vertical direction 1802, the die punch 1801 has reached the pusher 1810. Along with the continuing movement of the die punch 1801 in the vertical direction 1802, the movement of the die punch 1801 along the vertical direction 1802 is converted into a movement of the pusher 1810 along a horizontal direction 1812. The pusher 1810 then moves along the horizontal direction 1812 for contacting the J-lead. Thereby, the spring 1811 is starting to compress from its initial length along with the movement of the pusher 1810 in the horizontal direction 1812.

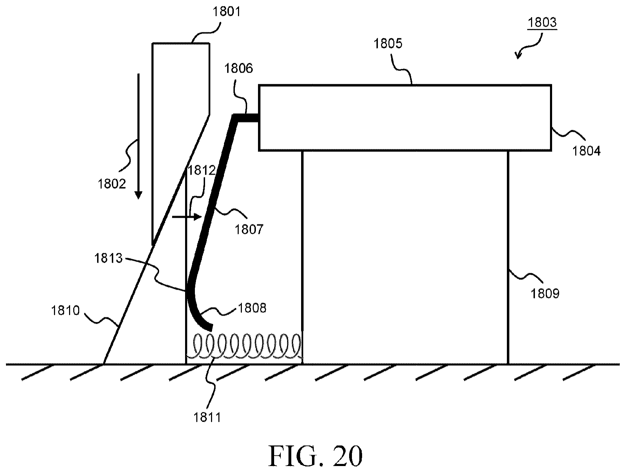

As shown in FIG. 20, along with the continuing movement of the die punch 1801 in the vertical direction 1802 and along with the continuing movement of the pusher 1810 in the horizontal direction 1812, the pusher 1810 has reached the J-lead at a contact point 1813 of the curved tip portion 1808. The pusher 1810 is in contact with the curved tip portion 1808. The spring 1811 is further compressed.

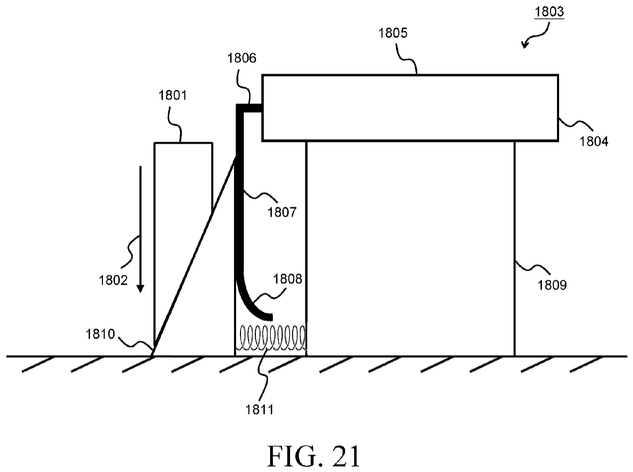

As shown in FIG. 21, along with the continuing movement of the pusher 1810 in the horizontal direction after the pusher 1810 is in contact with the curved tip portion 1808, the curved tip portion 1808 moves inward relative to the main body 1804, thereby leading the straight lead portion 1807 to move inward relative to the main body 1804 as well. The pusher 1810 stops at the position where the straight lead portion 1807 reaches approximately to the vertical direction and the spring 1811 terminates the further compression. Thus, the J-lead is deformed to a predetermined expected shape.

As the straight lead portion 1807 is connected with the curved tip portion 1808, the movement and the final position of the straight lead portion 1807 is defined by the distance of the inward movement of the curved tip portion 1808. The distance of the inward movement of the curved tip portion 1808 is correlated with the distance of the movement of the pusher 1810 along the horizontal direction, and the distance of the movement of the pusher 1810 along the horizontal direction is correlated with a sliding contact distance described in the first embodiment of the present disclosure, which relates to the movement of the die punch 1801 along the vertical direction when the die punch 1801 is in contact with the pusher 1810. That is to say, in order to accurately configure the straight lead portion 1807 to reach approximately to the vertical direction, an accurate movement of the die punch 1801 along the vertical direction is preconfigured for acquiring an expected sliding contact distance, thereby acquiring an expected movement distance of the pusher 1810 along the horizontal direction. A preferred sliding contact distance is around 6 millimeters, and a preferred movement distance of the pusher along the horizontal direction is around 1 millimeter.

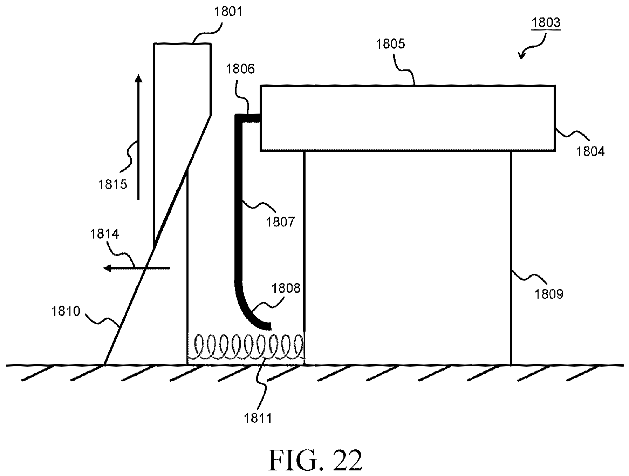

As shown in FIG. 22, when the accurate movement of the die punch 1801 along the vertical direction for contacting the pusher 1810 to acquire the expected sliding contact distance and the expected movement distance of the pusher 1810 along the horizontal direction has been implemented, the die punch 1801 is preconfigured to start to move back to its initial position along a vertical direction 1815. Along with the movement of the die punch 1801 in the vertical direction 1815, the spring 1811 is starting to extend from the compressed length, thereby leading the pusher 1810 to move along a horizontal direction 1814 for leaving away from the J-lead.

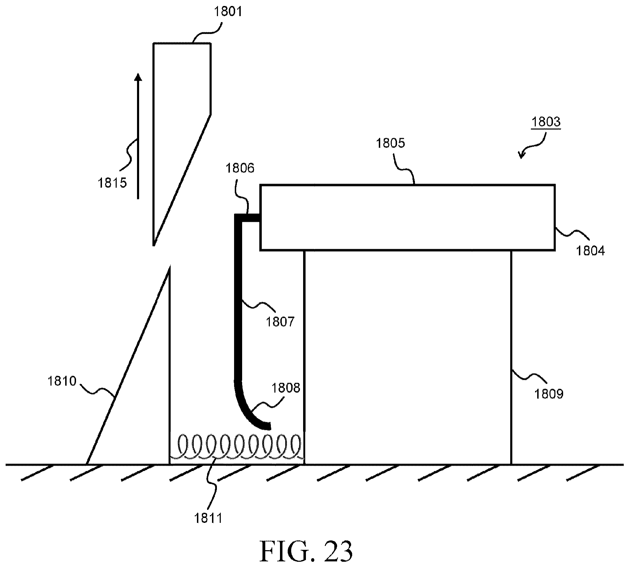

As shown in FIG. 23, along with the continuing movement of the die punch 1801 in the vertical direction 1815, the die punch 1801 is starting to leave away from the pusher 1810. The spring 1811 is further extending and restoring to its initial length. When the die punch 1801 has left the pusher 1810, the compressed spring 1811 is further extended to restore to its initial length, thereby leading the pusher 1810 to continue to move along the horizontal direction back to its initial position.

Comparing with the first and the second embodiment of the present disclosure, the solution of the third embodiment utilizes a spring coupled between the pusher and the supporting stand for limiting the relative positional relationship between the pusher and supporting stand during the compression of the spring from its initial length and the extension of the spring to restore to the initial length. In the third embodiment, there is no need for a user to manually reset the pusher to its initial position each time after a J-lead is deformed to an expected predetermined shape. This will further save cost and decrease design complexity for the pusher of the present disclosure. **It** will be appreciated that other shape memory materials and products excluding a spring are also applicable for the third embodiment of the present disclosure.

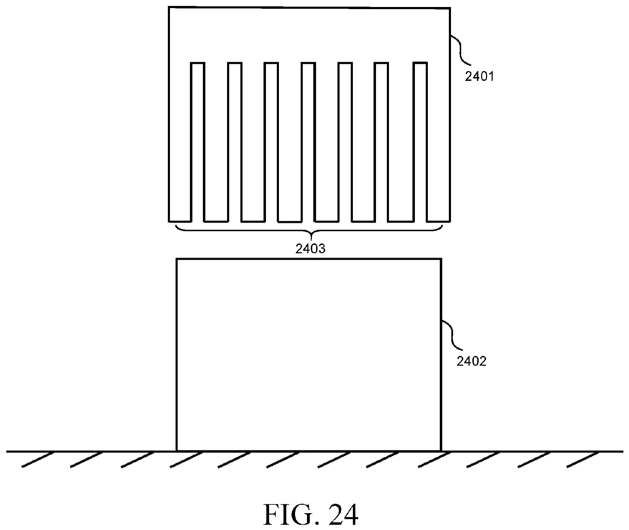

FIG. 24 shows a front view of an apparatus used for deforming a J-lead of a packaged semiconductor device in accordance with a fourth embodiment of the present disclosure. The pusher 2402 is placed on a ground or a working platform and the die punch 2401 is placed above the pusher 2402. As shown in FIG. 24, the front-view shape of the die punch 2401 comprises a finger structure 2403 at the bottom end of the die punch 2401. Each neighboring two fingers of the finger structure 2403 are spaced by a slot.

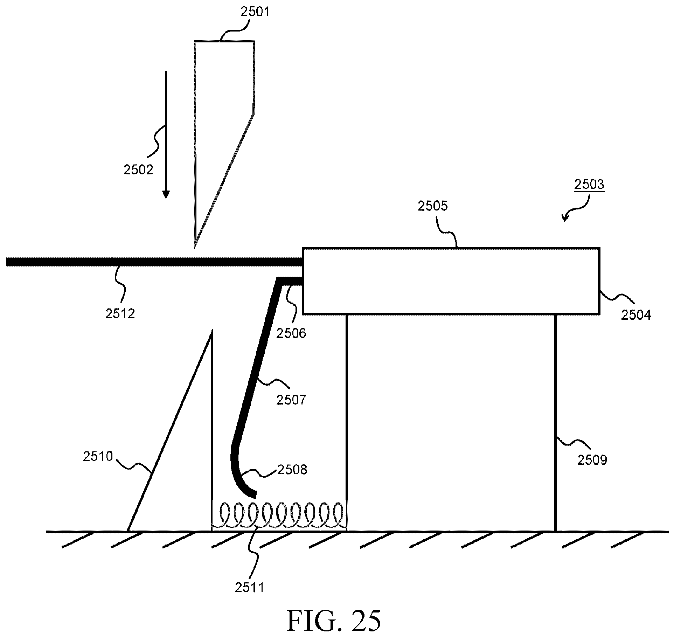

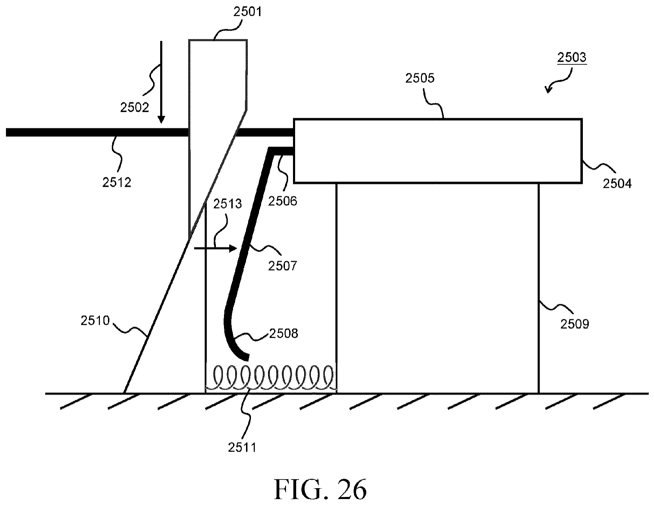

FIG. 25 and FIG. 26 show cross sections of intermediate steps of a process of using the apparatus for deforming a J-lead of a packaged semiconductor in accordance with the fourth embodiment of the present disclosure. The apparatus for deforming a J-lead of a packaged semiconductor shown in FIG. 25 to FIG. 26 are similar to those shown in FIG. 6 to FIG. 9, but in which a spring 2511 is coupled between the pusher 2510 and the supporting stand 2509. The spring 2511 is configured to be compressible/extendable along with the movement of the pusher 2510 along the horizontal direction. The packaged semiconductor device 2503 shown in FIG. 25 to FIG. 26 are similar to those shown in FIG. 6 to FIG. 9, but in which the packaged semiconductor device 2503 comprises two interstitial tiers of leads extended from the main body 2504. As depicted in the cross section of FIG. 25, only respective one lead of the two interstitial tiers of leads is shown for reference, however, the skilled person will appreciate that two interstitial tiers of leads of the packaged semiconductor device can extend from either side of the main body. In addition to the J-lead, another lead 2512 is also extended from the main body 2504 without any pre-deformed procedure. It will be appreciated that the lead 2512 can be already deformed or later deformed to a gull-wing lead, a J-shaped lead or other types of lead in another lead deforming process by using another apparatus other than the apparatus for deforming a J-lead of a packaged semiconductor in accordance with the present disclosure, and it will also be appreciated that the up down relationship of the two interstitial tiers of leads are not limited to the positional relationship as shown in FIG. 25. Other similar components are similarly labelled. As shown in FIG. 25, the die punch 2501 is configured to move along a vertical direction 2502 for contacting the pusher 2510.

As shown in FIG. 26, along with the movement of the die punch 2501 in the vertical direction 2502, the die punch 2501 has reached the pusher 2510. Along with the continuing movement of the die punch 2501 in the vertical direction 2502, the movement of the die punch 2501 along the vertical direction 2502 is converted into a movement of the pusher 2510 along a horizontal direction 2513. The pusher 2510 then moves along the horizontal direction 2513 for contacting the J-lead. Thereby, the spring 2511 is starting to compress from its initial length along with the movement of the pusher 2510 in the horizontal direction 2513. As shown in FIG. 26, the dropping of the die punch 2501 has already exceeded the height of the lead 2512, while the shape of the lead 2512 is completely unaffected by the movement of the die punch 2501 along the direction 2502 as the lead 2512 crosses through the die punch 2501. The skilled person will appreciate that other steps of the process of using the apparatus for deforming a J-lead of a packaged semiconductor in accordance with the fourth embodiment of the present disclosure are similar to or the same as described in the process of using the apparatus for deforming a J-lead of a packaged semiconductor in accordance with other embodiments of the present disclosure.

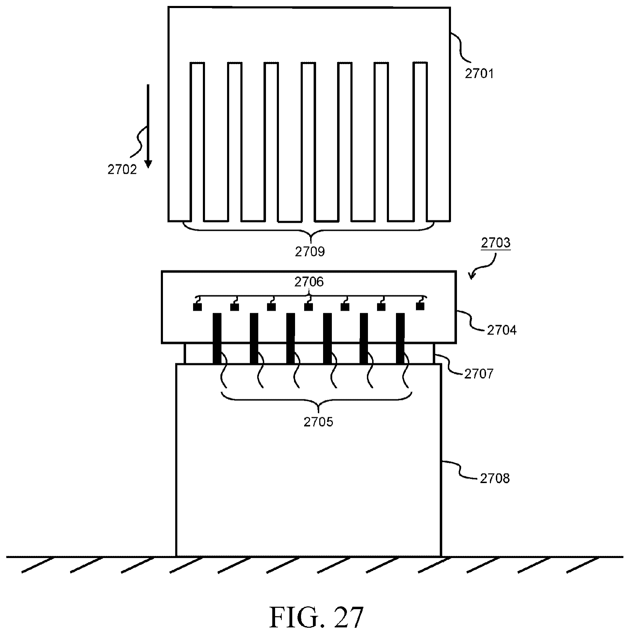

FIG. 27 shows a front view of the start of the process of using the apparatus for deforming a J-lead of a packaged semiconductor in accordance with the fourth embodiment of the present disclosure.

As shown in FIG. 27, the apparatus comprises two components, which are a pusher 2708 placed on a ground or a working platform and a die punch 2701 placed above the pusher 2708. The front-view shape of the die punch 2701 comprises a finger structure 2709 at the bottom end of the die punch 2701. Each neighboring two fingers of the finger structure 2709 are spaced by a slot. After a pre-described J-lead shoulder forming step, a packaged semiconductor device 2703 is placed on a supporting stand 2707. The supporting stand 2707 is placed on the same ground or the same working platform as the pusher 2708. The packaged semiconductor device 2703 comprises a main body 2704 and two interstitial tiers of leads extended from the main body 2704, which are J-leads 2705 finishing the shoulder forming step and another leads 2706 without any pre-deformed procedure. It will be appreciated that the leads 2706 can be already deformed or later deformed to gull-wing leads, J-shaped leads or other types of leads in another lead deforming process by using another apparatus other than the apparatus for deforming a J-lead of a packaged semiconductor in accordance with the present disclosure, and it will also be appreciated that the up down relationship of the two interstitial tiers of leads 2705, 2706 are not limited to the positional relationship as shown in FIG. 27. The width of the pusher 2708 covers all the J-leads 2705 to be deformed. As depicted in the front view of FIG. 27, six J-leads 2705 and seven another leads 2706 are shown for reference, however, the skilled person will appreciate that the plurality of leads of the packaged semiconductor device with no amount limitation can extend from either side of the main body. As shown in FIG. 27, the die punch 2701 is configured to move along a vertical direction 2702 for contacting the pusher 2708.

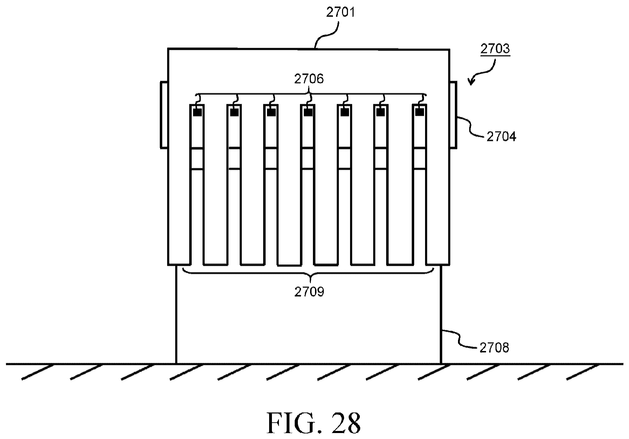

FIG. 28 shows a front view of the end of the process of using the apparatus for deforming a J-lead of a packaged semiconductor in accordance with the fourth embodiment of the present disclosure.

As shown in FIG. 28, when the J-leads 2705 (not shown in FIG. 28) are deformed to a predetermined expected shape, the die punch 2701 is in contact with the pusher 2708 but has not reached the ground or the working platform where the pusher 2708 is placed. It will be appreciated that the width of the die punch and the relative positional relationships of the die punch and the pusher from the start till the end of the process for deforming the leads are not limited as long as the movement and the contact of the die punch and the pusher can fulfill the function of deforming the J-lead described in the context of the present disclosure. As shown in FIG. 28, the leads 2706, which are not the J-leads to be deformed by the apparatus used for deforming a J-lead of a packaged semiconductor device in accordance with the present disclosure, are contained respectively in a slot between neighboring two fingers of the finger structure 2709 during the interval between the moment when the drop of the die punch 2701 along the vertical direction has reached the height of the leads 2706 and the end of the process for deforming the J-leads 2705 (not shown in FIG. 28).

The solution of the fourth embodiment utilizes a space between neighboring two fingers of a finger structure of the die punch for containing a lead which does not need to be deformed while at the same time a J-lead from other interstitial tier is configured to be deformed by the apparatus in accordance with the present disclosure. In the fourth embodiment, the solution offers an implementation for deforming J-leads from one interstitial tier of a High Density Quad Flat Package (HDQFP), while keeping the leads from another interstitial tier of the HDQFP, that does not need to be deformed during the J-lead deforming process, independent and unaffected. It will also be appreciated that other shapes of die punch that can fulfill the function of containing the leads which do not need to be deformed as the finger structure of the die punch in accordance with the fourth embodiment of the present disclosure are also applicable.

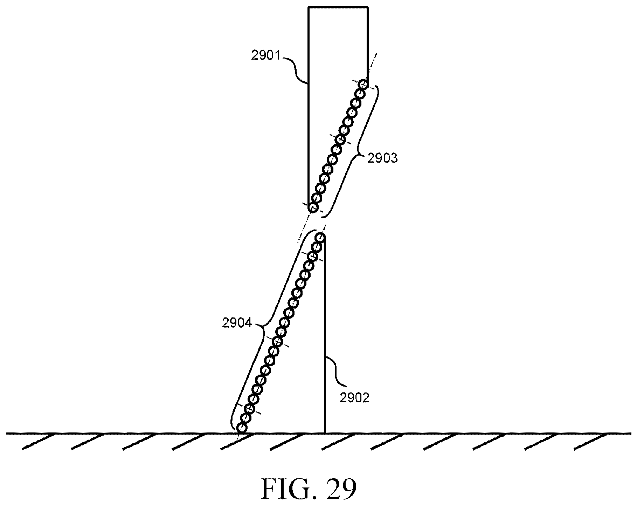

FIG. 29 shows a cross section of an apparatus used for deforming a J-lead of a packaged semiconductor device in accordance with a fifth embodiment of the present disclosure. The apparatus comprises two components, which are a pusher 2902 placed on a ground or a working platform and a die punch 2901 placed above the pusher 2902. As shown in FIG. 29, a side of the die punch 2901 comprises a plurality of rollers 2903 arranged in a row and a side of the pusher 2902 comprises a plurality of rollers 2904 arranged in a row. Each roller of the plurality of rollers 2903, 2904 are in a same diameter and is able to rotate along its own axis. Neighboring two rollers of the plurality rollers 2903, 2904 are seamlessly adjacent to each other and the rotation of one of the plurality rollers 2903, 2904 transmits to drive the rotation of its adjacent one roller. Each of the arrangement of the row of the plurality of rollers 2903 and the arrangement of the row of the plurality of rollers 2904 is at an angle preconfigured as 30° with regard to the vertical direction. **It** will be appreciated that the cross-section shapes of the pusher 2902 including the plurality of rollers 2904 and the die punch 2901 including the plurality of rollers 2903 are not limited to the shapes shown in FIG. 29. **It** will also be appreciated that the number of the plurality of rollers 2903, 2904 to be arranged at one side of the die punch 2901 and one side of the pusher 2902 is not limited to the amount shown in FIG. 29, and any sizes of the plurality of rollers 2903, 2904 that can fulfill the function of deforming the J-lead described in the context of the present disclosure are applicable.

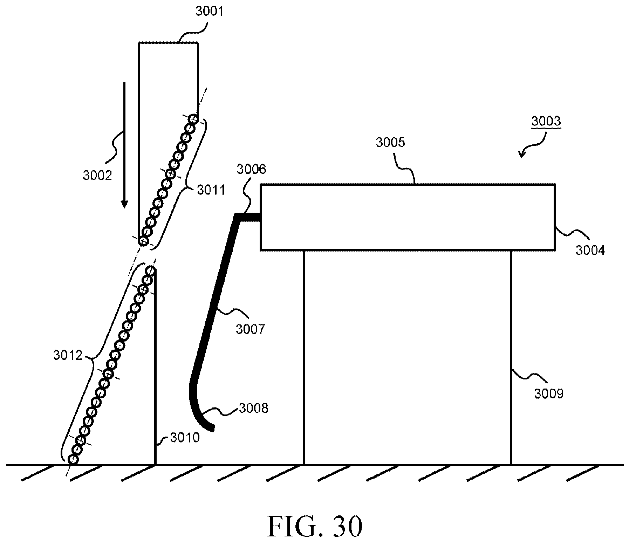

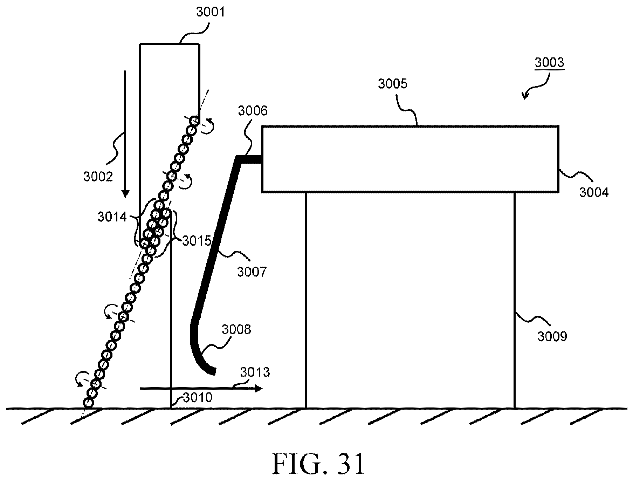

FIG. 30 and FIG. 31 show cross sections of intermediate steps of a process of using the apparatus for deforming a J-lead of a packaged semiconductor in accordance with the fifth embodiment of the present disclosure. The apparatus for deforming a J-lead of a packaged semiconductor shown in FIG. 30 to FIG. 31 are similar to those shown in FIG. 6 to FIG. 9, but in which a side of the die punch 3001 comprises a plurality of rollers 3011 arranged in a row and a side of the pusher 3010 comprises a plurality of rollers 3012 arranged in a row. Other similar components are similarly labelled. As shown in FIG. 30, the die punch 3001 is configured to move along a vertical direction 3002 for contacting the pusher 3010.

As shown in FIG. 31, along with the movement of the die punch 3001 in the vertical direction 3002, the die punch 3001 has reached the pusher 3010. Upon the die punch 3001 reaches the pusher 3010, a part of the plurality of rollers of the die punch 3001 is starting to engage with a part of the plurality of rollers of the pusher 3010. As shown in FIG. 31, five rollers 3014 of the die punch 3001 engages with five rollers 3015 of the pusher 3010. As a result of this rolling contact, the plurality of rollers of the die punch 3001 and the plurality of rollers of the pusher 3010 starts to rotate counterclockwise from the rolling contact section to the non-contact section as the above rotation transmission mechanism described. Along with the continuing movement of the die punch 3001 in the vertical direction 3002, the movement of the die punch 3001 along the vertical direction 3002 is converted into a movement of the pusher 3010 along a horizontal direction 3013. The pusher 3010 then moves along the horizontal direction 3013 for contacting the J-lead. The skilled person will appreciate that other steps of the process of using the apparatus for deforming a J-lead of a packaged semiconductor in accordance with the fifth embodiment of the present disclosure are similar to or the same as described in the process of using the apparatus for deforming a J-lead of a packaged semiconductor in accordance with other embodiments of the present disclosure.

The solution of the fifth embodiment utilizes a rolling contact between the die punch and the pusher instead of a sliding contact in accordance with other embodiments of the present disclosure. This will reduce the contact friction between the die punch and the pusher and further extend service life of the apparatus of the present disclosure.

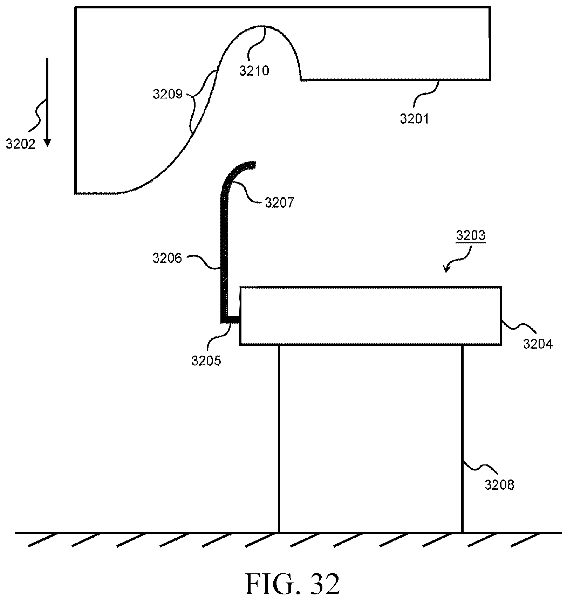

FIG. 32 to FIG. 34 show cross sections of a process of final forming step after a J-lead of a packaged semiconductor device is deformed by using the apparatus in accordance with the present disclosure.

As shown in FIG. 32, after the J-leads are deformed to predetermined expected shapes by using the apparatus for deforming a J-lead of a packaged semiconductor device in accordance with the described embodiments of the present disclosure, a packaged semiconductor device 3203 is placed on a supporting stand 3208. The skilled person will also appreciate and use other methods for fixing the packaged semiconductor device, such as placing the packaged semiconductor device on an anvil, clamping the packaged semiconductor device by using mechanical arms, etc. The packaged semiconductor device 3203 comprises a main body 3204 and a plurality of deformed J-leads. As depicted in the cross section of FIG. 32, only one deformed J-lead of the plurality of deformed J-leads is shown for reference, however, the skilled person will appreciate that the plurality of deformed J-leads of the packaged semiconductor device can extend from either side of the main body. As shown in FIG. 32, the deformed J-lead comprises a straight extended portion 3205, a straight lead portion 3206 and a curved tip portion 3207 after the pre-described J-lead deforming process. The deformed J-lead extends from the main body 3204 by the straight extended portion 3205 along a horizontal direction. The straight lead portion 3206 is at an angle of around 90° to the straight extended portion 3205 and connected between the straight extended portion 3205 and the curved tip portion 3207. The curved tip portion 3207 is curved beyond a vertical direction. A die punch 3201 moves along a vertical direction 3202 for contacting the deformed J-lead to finish a final forming for the deformed J-lead. The die punch 3201 has a polished groove 3210 of the same radius as is required for the final forming net shape of the J bend for the deformed J-lead. The groove 3210 has a lead-in 3209 adjacent to the groove 3210.

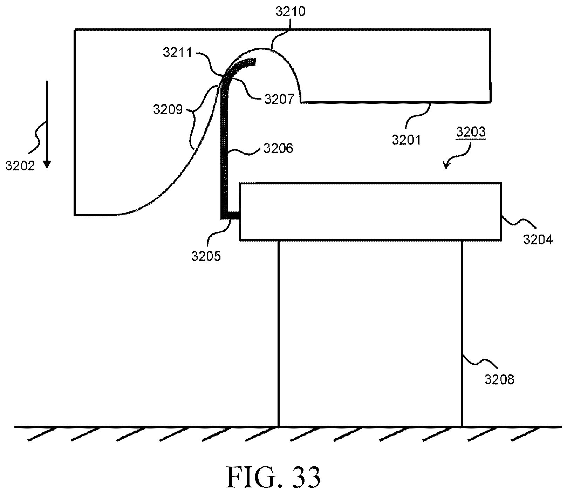

As shown in FIG. 33, along with the movement of the die punch 3201 in the direction 3202, the die punch 3201 starts to contact the deformed J-lead from the contact point 3211.

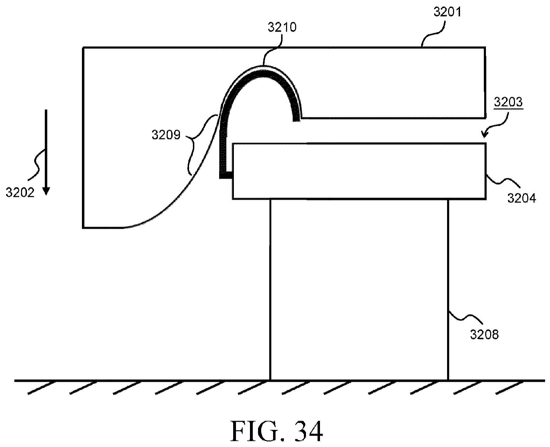

As shown in FIG. 34, along with the continuing movement of the die punch 3201 in the direction 3202, the groove 3210 in the die punch 3201 gives the final curl to the deformed J-lead and establish the overall height and width of the packaged outline as expected.

By using the apparatus for deforming a J-lead of a packaged semiconductor device in accordance with the present disclosure, in a final forming step, a deformed J-lead with an approximate vertical straight lead portion is able to directly be lead into the polished groove of the final forming die punch without a long distance of sliding for the tip portion and the straight lead portion of the J-lead along the lead-in 3209. This will tremendously reduce the tin scratch on the J-lead and avoid J-lead burrs which is brought by the bent of the straight lead portion of the J-lead from around 70° gradually to about 90° during the sliding along the lead-in 3209 in the final forming step.

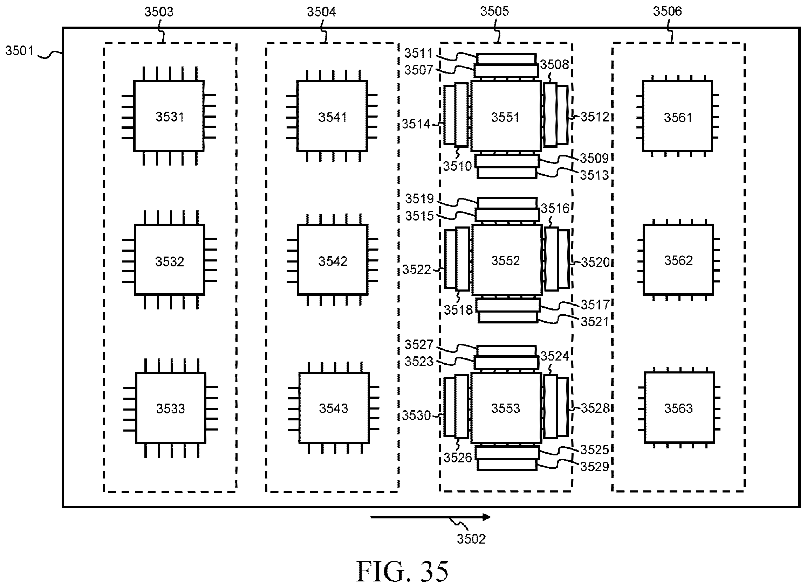

FIG. 35 depicts a top view of a first setup for configuring and arranging the apparatus of the present disclosure in industrial pipelines.

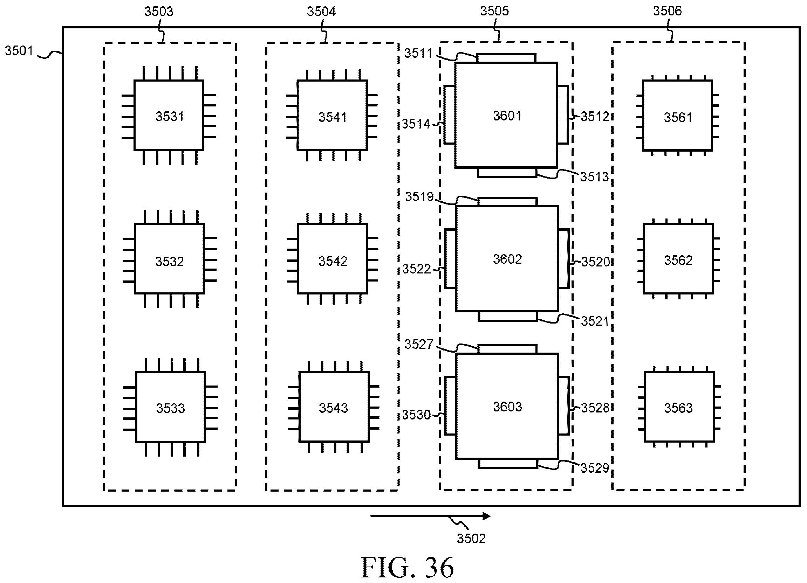

As shown in FIG. 35, a pipeline platform 3501 runs along a direction 3502. The pipeline is consist of four different functional sections, a tip forming step functional section 3503 with three packaged semiconductor devices 3531, 3532, 3533 arranged inside, a shoulder forming step functional section 3504 with three packaged semiconductor devices 3541, 3542, 3543 arranged inside, a J-lead deforming step functional section 3505 with three packaged semiconductor devices 3551, 3552, 3553 arranged inside and a final forming step functional section 3506 with three packaged semiconductor devices 3561, 3562, 3563 arranged inside. After a pre-processed singulation step, along with the movement of the pipeline in the direction 3502, each singulated packaged semiconductor device will be delivered to the tip forming step functional section 3503, the shoulder forming step functional section 3504, the J-lead deforming step functional section 3505 and the final forming step functional section 3506 in sequence for deforming the leads of each singulated packaged semiconductor device as described in accordance with the present disclosure (the apparatus used for the tip forming step functional section, the shoulder forming step functional section and the final forming step functional section is not shown in FIG. 36). For the J-lead deforming step functional section 3505, four apparatus for deforming a J-lead of a packaged semiconductor device in accordance with the present disclosure are arranged for each singulated packaged semiconductor device and each side of a main body of the singulated packaged semiconductor device is arranged with one corresponding apparatus. The apparatus comprises two components, which are a pusher placed on the pipeline platform and a die punch placed above the pusher. As shown in FIG. 35, the die punches 3507, 3508, 3509, 3510 and the pushers 3511, 3512, 3513, 3514 are arranged for the packaged semiconductor device 3551. The die punches 3515, 3516, 3517, 3518 and the pushers 3519, 3520, 3521, 3522 are arranged for the packaged semiconductor device 3552. The die punches 3515, 3516, 3517, 3518 and the pushers 3519, 3520, 3521, 3522 are arranged for the packaged semiconductor device 3552. The die punches 3523, 3524, 3525, 3526 and the pushers 3527, 3528, 3529, 3530 are arranged for the packaged semiconductor device 3553.

FIG. 36 depicts a top view of a second setup for configuring and arranging the apparatus of the present disclosure in industrial pipelines.

As shown in FIG. 36, each singulated packaged semiconductor device within the J-lead deforming step functional section 3505 is arranged with four pushers, one for each side of a main body of the singulated packaged semiconductor device. The four pushers share one corresponding common die punch placed above them. The common die punch 3601 and the pushers 3511, 3512, 3513, 3514 are arranged for the packaged semiconductor device 3551 (not shown in FIG. 36). The common die punch 3602 and the pushers 3519, 3520, 3521, 3522 are arranged for the packaged semiconductor device 3552 (not shown in FIG. 36). The common die punch 3603 and the pushers 3527, 3528, 3529, 3530 are arranged for the packaged semiconductor device 3553 (not shown in FIG. 36). In this way, by using a common die punch for each singulated packaged semiconductor device within the J-lead deforming step functional section, the design and configuration complexity of the die punch are reduced.

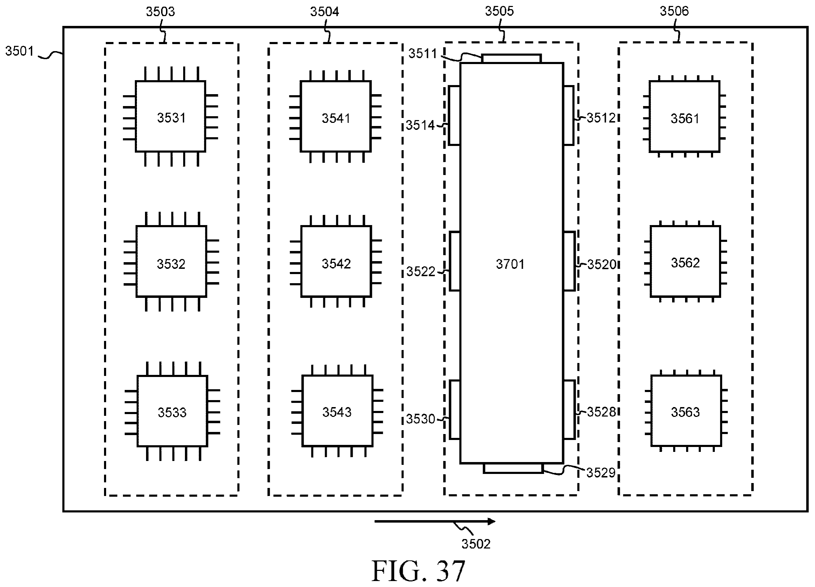

FIG. 37 depicts a top view of a third setup for configuring and arranging the apparatus of the present disclosure in industrial pipelines.

As shown in FIG. 37, each singulated packaged semiconductor device within the J-lead deforming step functional section 3505 is arranged with four pushers, one for each side of a main body of the singulated packaged semiconductor device. All the pushers of all the singulated packaged semiconductor devices within the J-lead deforming step functional section 3505 share one common die punch placed above them. The pushers 3511, 3512, 3513 (not shown in FIG. 37), 3514 are arranged for the packaged semiconductor device 3551 (not shown in FIG. 37). The pushers 3519 (not shown in FIG. 37), 3520, 3521 (not shown in FIG. 37), 3522 are arranged for the packaged semiconductor device 3552 (not shown in FIG. 37). The pushers 3527 (not shown in FIG. 37), 3528, 3529, 3530 are arranged for the packaged semiconductor device 3553 (not shown in FIG. 37). All the pushers share one common die punch 3701 placed above them. In this way, by using a common die punch for all singulated packaged semiconductor devices within the J-lead deforming step functional section, the design and configuration complexity of the die punch are further reduced.

It should be noted that, the arrangement of the apparatus for deforming a J-lead of a packaged semiconductor device in accordance with the present disclosure in industrial pipeline is not limited to the above described three setups. Also, the arrangement for different functional section, the amount of packaged semiconductor devices arranged for each functional section, a space between two neighboring packaged semiconductor devices, the operational mechanism of the pipeline platform, are also not limited to the above described three setups.

It will be appreciated that, any type of package, other than Quad Flat Packages (QFP), Plastic Leaded Chip Carrier (PLCC) packages and High Density Quad Flat Packages (HDQFP), which is featured with a J-shaped lead or benefit from adoption of a J-shaped lead, such as Dual In-Line Packages (DIPs), Single In-line Packages (SIPs), Small Outline Package (SOP/SO/SOIC), etc., can be adapted to utilize the apparatus for deforming a J-lead of a packaged semiconductor device in accordance with the present disclosure to deform its J-shaped leads with expected shapes.

The use of the terms 'a', 'an', 'the' and similar referents in the context of describing the subject matter (particularly in the context of the following claims) are to be construed to cover both the singular and the plural, unless otherwise indicated herein or clearly contradicted by context. Recitation of ranges of values herein are intended merely to serve as a shorthand method of referring individually to each separate value falling within the range, unless otherwise indicated herein, and each separate value is incorporated into the specification as if it were individually recited herein. Furthermore, the foregoing description is for the purpose of illustration only, and not for the purpose of limitation, as the scope of protection sought is defined by the claims set forth hereinafter together with any equivalents thereof entitled to. The use of any and all examples, or exemplary language (e.g., 'such as') provided herein, is intended merely to better illustrate the subject matter, and does not pose a limitation on the scope of the subject matter unless otherwise claimed. The use of the term 'based on' and other like phrases indicating a condition for bringing about a result, both in the claims and in the written description, is not intended to foreclose any other conditions that bring about that result. No language in the specification should be construed as indicating any non-claimed element as essential to the practice of the disclosure as claimed.

Preferred embodiments are described herein, including the best mode known to the inventor for carrying out the claimed subject matter. Of course, variations of those preferred embodiments will become apparent to those of ordinary skill in the art upon reading the foregoing description. The inventor expects skilled artisans to employ such variations as appropriate, and the inventor intends for the claimed subject matter to be practiced otherwise than as specifically described herein. Accordingly, this claimed subject matter includes all modifications and equivalents of the subject matter recited in the claims appended hereto as permitted by applicable law. Moreover, any combination of the above-described elements in all possible variations thereof is encompassed unless otherwise indicated herein or otherwise clearly contradicted by context.

## Claims

1. A method of using an apparatus to deform a J-shaped lead of a packaged semiconductor device, wherein the J-shaped lead comprises a straight extended portion, a straight lead portion and a curved tip portion, wherein the J-shaped lead extends from a main body of the packaged semiconductor device by the straight extended portion along a first direction which is parallel to a plane of a first major surface of the packaged semiconductor device, wherein the straight lead portion is at a first angle to the straight extended portion and connected between the straight extended portion and the curved tip portion, and wherein the curved tip portion is curved toward a direction perpendicular to the first direction, the method comprising:
moving a force component of the apparatus along a second direction which is perpendicular to the first direction; and
converting the movement of the force component along the second direction into a movement of a pusher component of the apparatus along a third direction which is opposite to the first direction by means of a transfer mechanism, wherein the pusher component is configured to be in contact with the curved tip portion,
wherein during the pusher component is in contact with the curved tip portion, the movement of the pusher component along the third direction results in an inward movement of the curved tip portion relative to the main body of the packaged semiconductor device, thereby deforming the J-shaped lead.

2. The method of claim 1, wherein deforming the J-shaped lead further comprises moving the curved tip portion inward until the straight lead portion reaches approximately perpendicular to the first direction.

3. The method of claim 1 or claim 2, wherein the transfer mechanism comprises a sliding contact between a surface of the force component and a surface of the pusher component, wherein both the surface of the force component and the surface of the pusher component for the sliding contact are planar and at a second angle to the second direction.

4. The method of claim 3, wherein a distance of the inward movement of the curved tip portion is correlated with a distance of the movement of the pusher component along the third direction, and wherein the distance of the movement of the pusher component along the third direction is configured by a distance of the sliding contact.

5. The method of claim 1, wherein the transfer mechanism comprises a rolling contact between a side of the force component and a side of the pusher component, wherein each of the side of the force component and the side of the pusher component for the rolling contact comprises a plurality of rollers, and wherein the plurality of rollers of the force component are configured to engage with the plurality of rollers of the pusher component.

6. The method according to any preceding claim, wherein the pusher component comprises a protruding structure, wherein the protruding structure is configured to insert into a hollow groove of a supporting stand of the apparatus as a result of the movement of the pusher component along the third direction, wherein the supporting stand is configured to support the main body of the packaged semiconductor device, and wherein a distance of the inward movement of the curved tip portion is correlated with a distance of the movement of the pusher component along the third direction, and wherein the distance of the movement of the pusher component along the third direction is configured by a length of a portion of the protruding structure, which portion is inserted into the hollow groove.

7. The method of claim 6, further comprising:
in response to the portion of the protruding structure being inserted into the hollow groove by a predetermined distance, moving the force component along a fourth direction which is opposite to the second direction.

8. The method according to any preceding claim, wherein a spring is coupled between the pusher component and a supporting stand of the apparatus, wherein the supporting stand is configured to support the main body of the packaged semiconductor device, and wherein the spring is configured to be compressible from an initial length as a result of the movement of the pusher component along the third direction.

9. The method of claim 8, further comprising:
moving the force component along a fourth direction which is opposite to the second direction,
wherein along with the movement of the force component in the fourth direction, the compressed spring is configured to be restored to the initial length, and the pusher component is configured to be movable along the first direction.

10. The method according to any preceding claim, wherein the force component comprises a finger structure at one end of the force component, and wherein a space between neighboring two fingers of the finger structure is configured to, during the movement of the force component along the second direction, contain a lead which does not need to be deformed.

11. An apparatus for deforming a J-shaped lead of a packaged semiconductor device, wherein the J-shaped lead comprises a straight extended portion, a straight lead portion and a curved tip portion, wherein the J-shaped lead extends from a main body of the packaged semiconductor device by the straight extended portion along a first direction which is parallel to a plane of a first major surface of the packaged semiconductor device, wherein the straight lead portion is at a first angle to the straight extended portion and connected between the straight extended portion and the curved tip portion, and wherein the curved tip portion is curved toward a direction perpendicular to the first direction, the apparatus comprising:
a force component; and
a pusher component,
wherein the force component is configured to be movable along a second direction which is perpendicular to the first direction,
wherein the movement of the force component along the second direction is convertible into a movement of the pusher component along a third direction which is opposite to the first direction by means of a transfer mechanism, wherein the pusher component is configured to be in contact with the curved tip portion, and
wherein during the pusher component is in contact with the curved tip portion, the movement of the pusher component along the third direction results in an inward movement of the curved tip portion relative to the main body of the packaged semiconductor device, thereby deforming the J-shaped lead.

12. The apparatus of claim 11, wherein deforming the J-shaped lead further comprises moving the curved tip portion inward until the straight lead portion reaches approximately perpendicular to the first direction.

13. The apparatus of claim 11 or claim 12, wherein the transfer mechanism comprises a sliding contact between a surface of the force component and a surface of the pusher component, wherein both the surface of the force component and the surface of the pusher component for the sliding contact are planar and at a second angle to the second direction.

14. The apparatus of claim 13, wherein a distance of the inward movement of the curved tip portion is correlated with a distance of the movement of the pusher component along the third direction, and wherein the distance of the movement of the pusher component along the third direction is configured by a distance of the sliding contact.

15. The apparatus of claim 11, wherein the transfer mechanism comprises a rolling contact between a side of the force component and a side of the pusher component, wherein each of the side of the force component and the side of the pusher component for the rolling contact comprises a plurality of rollers, and wherein the plurality of rollers of the force component are configured to engage with the plurality of rollers of the pusher component.
